# EUROPEAN PATENT SPECIFICATION

(11) **EP 2 473 863 B1**
(45) Date of publication and mention of the grant of the patent: **14.10.2015**
(21) Application number: 10811297.0
(22) Date of filing: 29.08.2010
(51) Int. Cl.: G01R 31/34, G01R 19/145, H02H 3/13, H02H 7/09, G01R 31/02, H02P 6/12

(54) **OPEN PHASE DETECTION SYSTEM AND METHOD FOR THREE-PHASE MOTOR**
SYSTEM UND VERFAHREN ZUR ERKENNUNG OFFENER PHASEN FÜR EINEN DREIPHASENMOTOR
SYSTÈME ET PROCÉDÉ DE DÉTECTION DE COUPURE DE PHASE POUR UN MOTEUR TRIPHASÉ

(30) Priority: 31.08.2009 CN 200910189812
(43) Date of publication of application: 11.07.2012
(73) Proprietor: BYD Company Limited, Shenzhen, Guangdong 518118 (CN)
(72) Inventor: TANG, Xiaohua, Guangdong 518118 (CN); DU, Zhiyong, Guangdong 518118 (CN); ZHOU, Yongzhuang, Guangdong 518118 (CN); XIA, Cong, Guangdong 518118 (CN); CHENG, Lipin, Guangdong 518118 (CN); MA, Hui, Guangdong 518118 (CN)
(74) Representative: Gulde & Partner
(86) International application number: PCT/CN2010/076444
(87) International publication number: WO 2011/023137

(56) References cited:
- EP-A1- 1 873 002
- WO-A1-03/069768
- CN-A- 1 085 356
- CN-A- 1 423 388
- CN-U- 2 034 747
- CN-Y- 2 149 046
- CN-Y- 2 196 834
- JP-A- 2003 302 434
- JP-A- 2005 010 066
- JP-A- 2005 117 788
- JP-A- 2005 304 129
- US-A1- 2005 073 273

## Description

### CROSS-REFERENCE TO RELATED APPLICATIONS

The present application claims priority to and benefits of Chinese Patent Application No. 200910189812.4 filed with SIPO on August 31, 2009, the entirety of which is hereby incorporated by reference.

### BACKGROUND

### TECHNICAL FIELD

The present disclosure relates to an open phase detection system and method for a three-phase motor.

### DESCRIPTION OF THE RELATED ART

An open phase of a three-phase motor is that one phase current of three-phase alternating currents loaded on a three-phase motor may be lacked. During start-up or normal operation of the motor, open phase may cause the motor unable to start, or reduce the dynamic performance of the motor, more seriously, may cause short-circuit and burnout of the motor due to over high current and over heating. Thereby, open phase detection of the three-phase alternating currents of the motor is necessary during start-up and normal operation of the motor. At present, the detection of open phase of the three-phase motor is generally realized by detecting a phase difference between the three-phase voltages using a detection circuit. However the detection circuit may comprise many components and have a complex structure.

US2005073273A which is regarded as closest prior art, 1 provides a novel control system for a multiphase motor. The control system involves energization circuitry for energizing each phase winding, and a control circuit for defining phase currents for individual phases of the motor to generate control signals applied to the energization circuitry for energization of the phase windings. When at least one phase of the motor fails, a mode selection circuit enables the control circuit to operate either in a non-correction mode or in a fault-correction mode. In the non-correction mode of operation, phase currents for phases that remain operational are maintained unmodified. In the fault-correction mode, the phase currents for the remaining phases are modified in accordance with pre-set parameters.

EP1873002A1 provides an electric vehicle control device which is capable of detecting even a state in which only one phase of one induction motor is disconnected in a system where a plurality of induction motors are connected in parallel with each other and driven by one vector-controlled inverter device.; The electric vehicle control device according to the present invention includes a torque calculation unit (5) for calculating the torque of the induction motor on the basis of a q-axis current I1q, a d-axis current I1d, a q-axis voltage command E1qr, a d-axis voltage command E1dr, and an inverter angular frequency Éinv, which are obtained by a vector control unit (2), a torque variation width calculation unit (6) that calculates the torque variation width from a maximum value and a minimum value of a torque calculation result in a predetermined time width on the basis of the torque calculation result, and a comparator (7) that outputs a disconnection detection signal when the torque variation width exceeds the torque variation width reference value.

CN1085356A provides a protector for three-phase asynchronous motor composed of current detection circuit and control circuit. Said current detection circuit uses three-phase current/voltage mutual inductor and said control circuit consists of rectifier-filter, phase loss protector, overload/overcurrent protector, block protector, master control gate, driver, phase loss remember and display circuits, overcurrent/overload remember and display circuits, and state display. It features high detection precision, wide linear range and unsaturation of iron core.

### SUMMARY

The present disclosure is directed to solve at least one of the problems in the prior art.

Accordingly, the present disclosure provides a detection system for a three-phase motor open phase with simple structure.

According to an embodiment of the present disclosure, there is provided an open phase detection system for a three-phase motor of a vehicle, said system comprising: a signal generating unit coupled to the three-phase motor and configured to generate a driving signal for driving the three-phase motor; a detecting unit coupled to the signal generating unit, and configured to detect whether the signal generating unit generates the driving signal and to detect three-phase pulse width modulation, PWM, current values of the three-phase motor; and a determining unit coupled to the detecting unit, and configured to determine whether the three-phase motor has open phase according to the three phase PWM current values detected by the detecting unit when the driving signal was detected, wherein the detecting unit further comprises: a rotational speed detecting module configured to detect a rotational speed of a vehicle wheel; and a rotor position detecting module configured to detect a rotor position of the three-phase motor, wherein the determining unit is further configured to determine whether the three-phase motor has open phase according to the rotational speed of the vehicle wheel, the rotor position of the three-phase motor, a predetermined duty ratio value a0 of the three phase PWM current values of the three-phase motor, and the detected three-phase PWM current values.

According to another embodiment of present disclosure, there is provided an open phase detection method for a three-phase motor of a vehicle, said method comprises the steps of: detecting whether a driving signal is generated; detecting three phase pulse width modulation, PWM, current values of the three-phase motor when the driving signal is detected; and determining whether the three-phase motor has open phase according to the detected three phase PWM current values, wherein the method further comprises: detecting whether a rotational speed of a vehicle wheel is zero when the driving signal is detected; and determining whether one of the three-phase PWM current values is zero when the rotational speed of a vehicle wheel is not zero; and determining the three-phase motor to have open phase when one of the three phase PWM current values is zero, wherein the method further comprises: determining whether the three-phase motor has open phase according to the rotational speed of the vehicle wheel, a rotor position of the three-phase motor, a predetermined duty ratio value a0 of the three phase PWM current values of the three-phase motor, and the three-phase PWM current values.

The detection system and method according to the present disclosure realizes the open phase detection for the motor by detecting the three-phase current value and has a simple structure.

### BRIEF DESCRIPTION OF THE DRAWINGS

Fig. 1 shows a structural block diagram of the open phase detection system according to an embodiment of the present disclosure;
Fig. 2 shows a relationship of the duty ratios of the three-phase currents corresponding to sectors of the present disclosure;
Fig. 3 shows a structural block diagram of the open phase detection system according to another embodiment of the present disclosure;
Fig. 4 shows a flow chart of the open phase detection method according to the first embodiment of the present disclosure;
Fig. 5 shows a flow chart of the open phase detection method according to the second embodiment of the present disclosure;
Fig. 6 shows a flow chart of the open phase detection method according to the third embodiment of the present disclosure.

### DETAILED DESCRIPTION

These and other aspects, solutions and advantages of the disclosure will become apparent and more readily appreciated from the following descriptions taken in conjunction with the drawings, and the embodiments should be considered as an explanation instead of limitation to the disclosure.

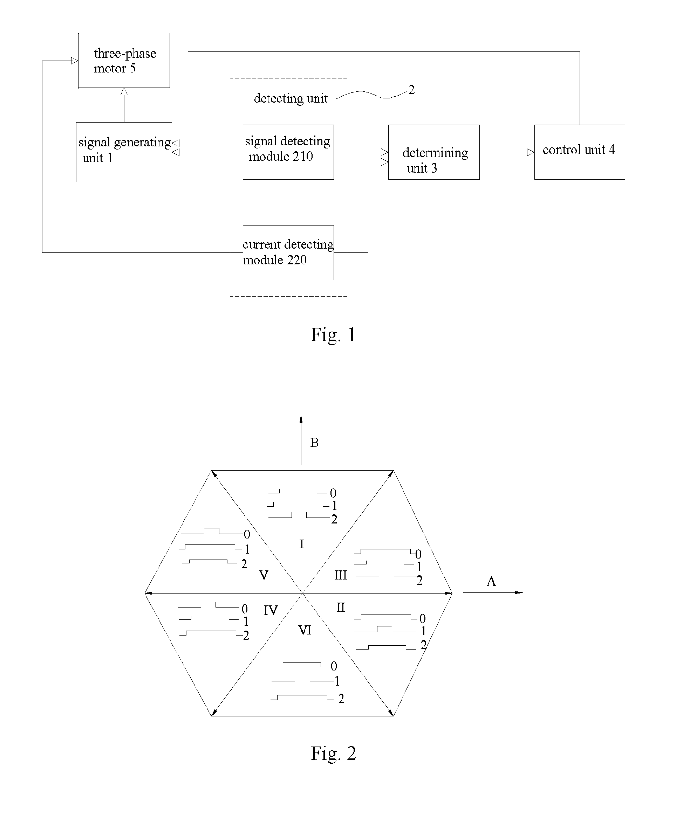

As shown in Fig. 1, according to an embodiment of the present disclosure, an open phase detection system for a three-phase motor 5 comprises a detecting unit 2, a determining unit 3, a signal generating unit 1 and a control unit 4. The signal generating unit 1 may be electrically coupled with the three-phase motor 5. The detecting unit 2 may be electrically coupled with the signal generating unit 1 and the determining unit 3 respectively. The control unit 4 may be electrically coupled with the determining unit 3 and the signal generating unit 1 respectively.

The signal generating unit 1 is used to generate a driving signal for driving the three-phase motor 5.

The detecting unit 2 may include a signal detecting module 210 used to detect whether the signal generating unit 1 generates the driving signal; and a current detecting module 220 used to detect the three phase current values of the three-phase motor 5.

The determining unit 3 is used to receive the three-phase currents from the detecting unit 2, and to determine whether one of the three-phase current values is zero. When one of three-phase current values is zero, the three-phase motor 5 is determined to have open phase.

According to another embodiment of the present disclosure, in order to protect the three-phase motor 5 when open phase occurs, The control unit 4 may control the signal generating unit 1 to stop generating the driving signal according to the open phase determination of the determining unit 3.

The open phase detection is performed by controlling the three-phase motor using the space vector pulse width modulation (SVPWM) technology. The technical principle of SVPWM is that: during the three-phase symmetric sinusoidal wave voltage supplying power, a three-phase symmetric motor stator ideal flux circle is used as a reference standard, different switch modes of a three-phase inverter may be used to make appropriate switching, so as to form PWM waves, and an actual flux linkage vector may be formed to trace the accurate flux circle. According to the SVPWM control technology, the different switch modes of a three-phase inverter may divide the 360 degree voltage space into six sectors. As shown in Fig. 2, I, V, IV, VI, II and III sectors may be successively defined. The above sectors may be used to determine a rotor position of the three-phase motor. In each sector, 0, 1 and 2 waves are respectively corresponded to waves of three-phase currents IA, IB and IC. Reference to Fig. 2, the duty ratio a1 of A-phase current value IA in I and VI sectors is equal to that the duty ratio a2 of B-phase current value IB subtracts the duty ratio a3 of C-phase current value IC. Meanwhile, the duty ratio a1 of A-phase current value IA is equal to a predetermined duty ratio value a0, the A-phase current inrushing time is same as the A-phase current outflowing time, so that the currents are offset and the A-phase current value is zero. Similarly, reference to Fig. 2, the duty ratio a2 of B-phase current only in III and IV sectors is equal to the predetermined duty ratio value a0, that is, the B-phase current IB only in III and IV sectors is zero; the duty ratio a3 of C-phase current IC only in II and V sectors is equal to the predetermined duty ratio value a0, that is, the C-phase current IC only in II and V sectors is zero. In addition, the duty ratio of the predetermined duty ratio value a0 may be about 45%-55%.

In some embodiments of the present disclosure, the basic principle of open phase detection for the three-phase motor is that: when a phase current value is zero, open phase is determined to occur. However, when the motor is used to a vehicle, during climbing of the vehicle, the vehicle is anchoring on the slope, at that time, the motor is in operation and has no rotational speed, the motor may be in a condition of locked rotor and thereby a phase current loaded on the motor may be permitted to be zero, so that the motor does not has open phase in this situation, and an erroneous judgment on this situation may be avoided according to the sectors and duty ratio.

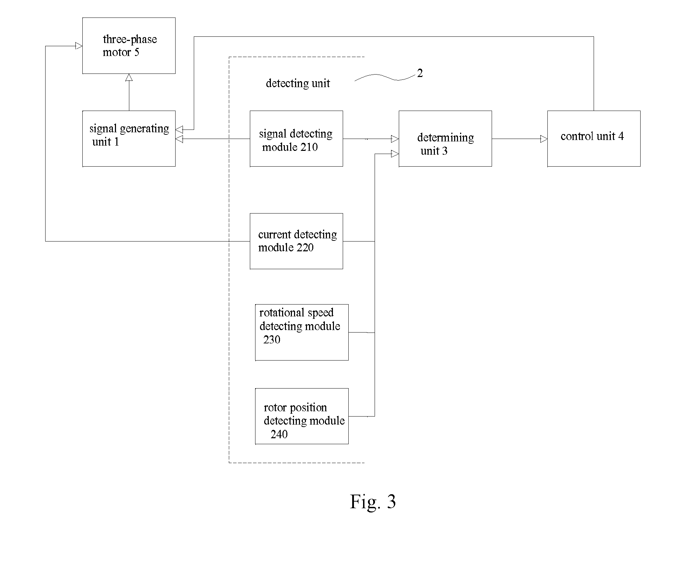

As shown in Fig. 3, the detecting unit 2 further comprises a rotational speed detection module 230 used to detect a rotational speed of a vehicle wheel; and a rotor position detection module 240 used to detect a rotor position of the three-phase motor 5. Only when the rotation speed of the vehicle is zero and one phase current value is zero, it is necessary to determine the sector in which the rotor is positioned and the duty ratio of the one phase current so as to confirm whether the one phase is open phase. The rotor position detection module 240 is used to detect a rotor position of the three-phase motor 5, that is, to detect the sector in which the rotor is positioned, then to send the detection to the determining unit 3. The rotor position detection module 240 may detect the rotor position by a rotating transformer. When the rotor position is in I and VI sectors and the duty ratio a1 of the A-phase current IA is equal to the predetermined duty ratio value a0, even if the A-phase current value IA is zero, the A-phase of the three-phase motor is not open phase. Similarly, when the rotor position is in III and IV sectors and the duty ratio a2 of the B-phase current IB is equal to the predetermined duty ratio value a0, even if the B-phase current value IB is zero, the B-phase of the three-phase motor is not open phase. When the rotor position is in II and V sectors and the duty ratio a3 of the C-phase current IC is equal to the predetermined duty ratio value a0, even if the C-phase current value is zero, the C-phase of the three-phase motor is not open phase.

In some embodiments, due to the three-phase currents loaded on the motor may easily jump, to avoid the situation of instant current being zero is determined as open phase fault, so as to reduce the misjudgment, the detecting unit 2 may further comprise a current counter used to count the detected currents, a current accumulator and a current calculator used to calculate an average value of the current values.

The control unit 4 may control the signal generating unit 1 to stop generating the driving signal every time the open phase is detected, which may reduce the work efficiency of the motor, in order to avoid the above situation, the control unit 4 may further comprise an open phase counter used to accumulate times of open phase and reset the current accumulator according to determination of the determining unit 3. When times of open phase reaches a set value n1, the motor is determined to have open phase, that is, when F is equal to 1, the control unit 4 controls the signal generating unit 1 to stop generating the driving signal.

According to embodiments of the present disclosure, the determining unit 3, the signal generating unit 1 and the control unit 4 may be integrated into a piece of chip such as TMS320F2812DSP chip. The three-phase motor may be a permanent magnet synchronous motor, the detecting unit 2 may be a current sensor and a rotational speed sensor of a vehicle wheel.

The present disclosure further disclosed an open phase detection method for a three-phase motor, comprising steps of: detecting whether the signal generating unit 1 generates a driving signal; detecting three phase current values of the three-phase motor 5 when the driving signal is detected; and determining whether the three-phase motor 5 has open phase according to the detected three phase current values by the determining unit 3.

In some embodiments, open phase detection method may further comprise stopping generating the driving signal when the three-phase motor 5 is determined by the determining unit 3 to have open phase.

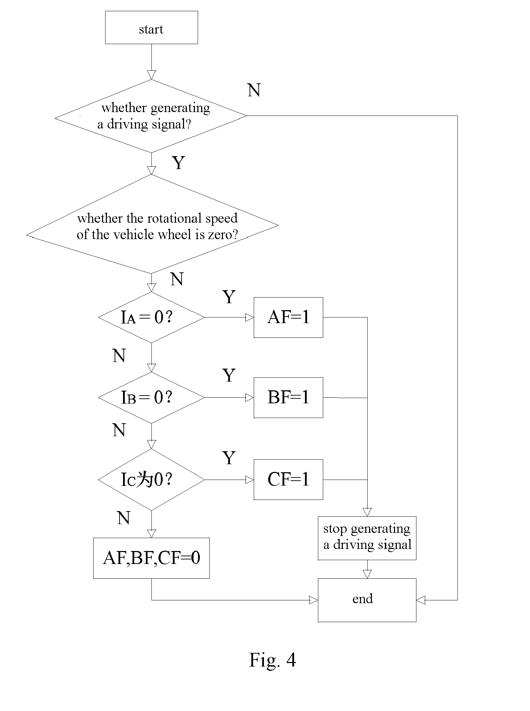

As shown in Fig. 4, the first embodiment of open phase detection method may comprise detecting whether the signal generating unit 1 generates a driving signal, terminating the process when the driving signal is not detected; when the driving signal is detected, further detecting whether a rotational speed of a vehicle wheel is zero; determining whether one of the three phase current values is zero when the rotational speed of the vehicle wheel is not zero.

When none of the phase current values of the three phase is zero, that is, IA ≠ 0 , IB ≠ 0, and IC ≠0, it is determined to have no open phase, and the process is terminated.

When one phase current value is zero, that is IA=0, IB=0 or IC=0; that is, AF=1, BF=1 or CF=1, the motor is determined to have open phase.

When the open phase is determined by the determining unit 3, the control unit 4 may control the signal generating unit 1 to stop generating the driving signal.

With open phase detection method of the first embodiment of the present disclosure, the three-phase currents may be determined in turn from A-phase to C-phase, or from C-phase to A-phase. The determining order of the three-phase currents may be randomly combined and not limited to above. Only when AF, BF and CF are all equal to zero, the three-phase motor 5 is determined to have no open phase; if any one of AF, BF and CF is equal to one, the three-phase motor 5 is determined to have open phase.

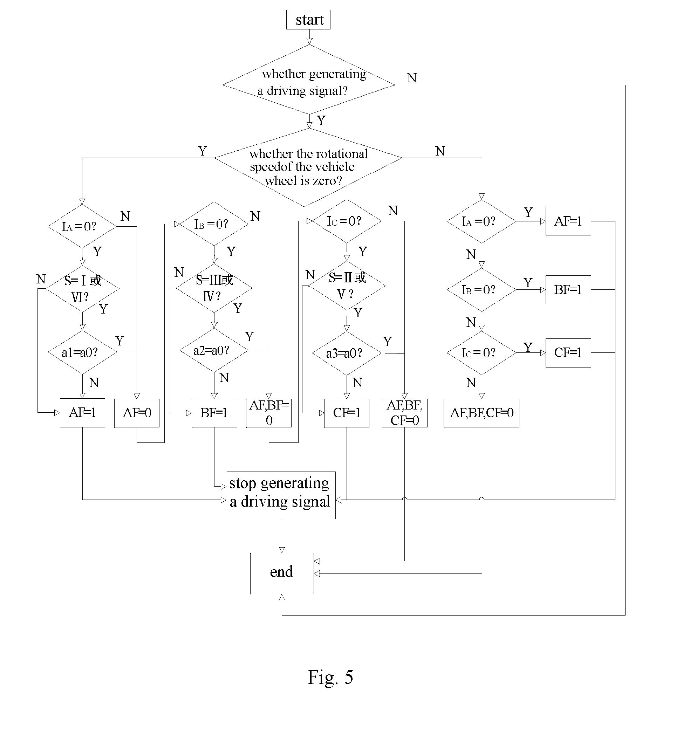

During climbing of a vehicle, the vehicle is anchoring on a slope, at that time, the motor is in operation and has no rotational speed. The motor may be under a condition of locked rotor, and a phase current loaded on the motor may be zero, but the motor does not have open phase in this situation. To avoid the misjudgment in this situation, as shown in Fig. 5, the second embodiment of the present disclosure may further comprise the following steps:
when the rotational speed of the vehicle wheel is zero, the determining unit 3 may determine whether the A-phase current value IA is zero;
when the A-phase current value IA is zero, the determining unit 3 may further determine whether the rotor position of the three-phase motor is in I or VI sector;
when the rotor position of the three-phase motor 5 is not in I or VI sector, the motor is determined to have open phase, that is AF=1, and the control unit 4 may control signal generating unit 1 to stop generating a driving signal;
when the rotor position of the three-phase motor 5 is in I or VI sector, it is further determined whether a duty ratio a1 of A-phase current is equal to a predetermined duty ratio value a0;
if the duty ratio a1 of A-phase current is not equal to the predetermined duty ratio value a0, the motor is determined to have open phase, that is AF=1, and the control unit 4 may control signal generating unit 1 to stop generating a driving signal;
if the duty ratio a1 of A-phase current is equal to the predetermined duty ratio value a0, it is determined that A-phase is not open phase, that is AF=0;
when the A-phase current value is not zero, it is determined that the A-phase is not open phase, that is AF=0.
when AF=0, it is determined whether the B-phase current value is zero;

When the B-phase current value is zero, the determining unit 3 determines whether the rotor position of the three-phase motor 5 is in III or IV sector;
if the rotor position of the three-phase motor is not in III or IV sector, the motor is determined to have open phase, that is BF=1, and the control unit 4 may control signal generating unit 1 to stop generating a driving signal;
when the rotor position of the three-phase motor 5 is in III or IV sector, it is further determined whether a duty ratio a2 of B-phase current IB is equal to the predetermined duty ratio value a0;

If the duty ratio a2 of B-phase current IB is not equal to the predetermined duty ratio value a0, the motor is determined to have open phase, that is BF=1, and the control unit 4 may control signal generating unit 1 to stop generating a driving signal;
when the duty ratio a2 of B-phase current IB is equal to the predetermined duty ratio value a0, it is determined that the A-phase and B-phase are not open phase, that is AF=0 and BF=0;
when AF=0 and BF=0, it is further determined whether the C-phase current is zero;
when the C-phase current value IC is not zero, the motor is determined to have no open phase, that is AF=0, BF=0 and CF=0, and the process is terminated;
when the C-phase current value IC is zero, the determining unit 3 further determines whether the rotor position of the three-phase motor 5 is in II or V sector;
if the rotor position of the three-phase motor is not in II or V sector, the motor is determined to have open phase, that is CF=1, the control unit 4 may control signal generating unit 1 to stop generating the driving signal;
when the rotor position of the three-phase motor 5 is in II or V sector, it is further determined whether a duty ratio a3 of the C-phase current IC is equal to the predetermined duty ratio value a0;
if the duty ratio a3 of C-phase current IC is equal to the predetermined duty ratio value a0, the motor is determined to have no open phase, that is AF=0, BF=0 and CF=0, and the process is terminated;
when the duty ratio a3 of the C-phase current IC is not equal to the predetermined duty ratio value a0, the motor is determined to have open phase, that is CF=1, the control unit 4 may control signal generating unit 1 to stop generating a driving signal.

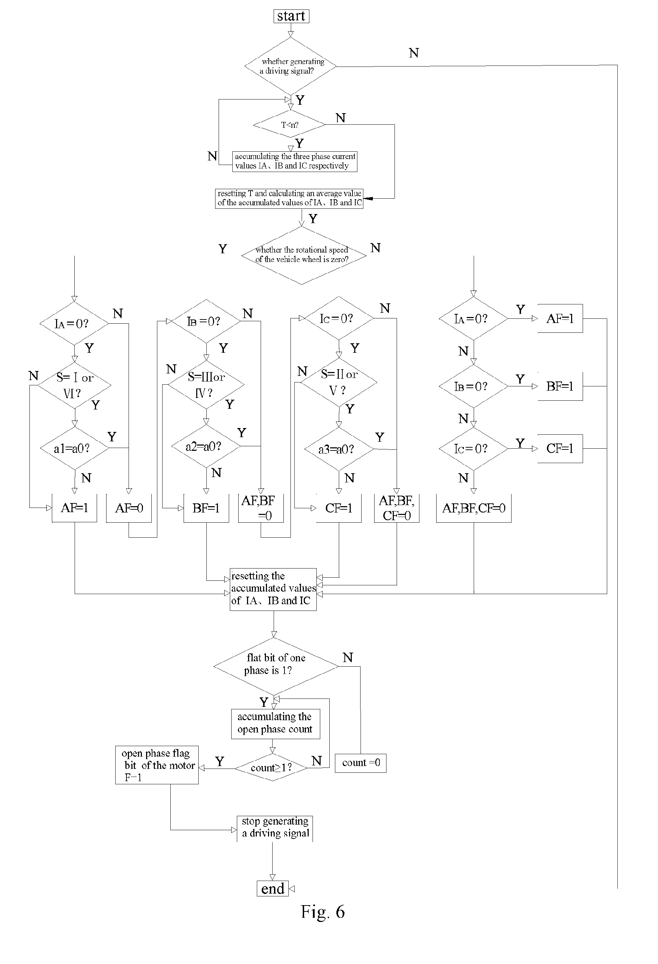

Because the three-phase currents loaded on the motor may easily jump, to avoid the situation of instant current being zero is determined as the motor has open phase, and to avoid decrease of the work efficiency of the motor, after the generating unit 1 generates a driving signal, as shown in Fig. 6, according to the third embodiment of the present disclosure, open phase detection method further comprises the following steps:
when the detecting unit 2 detects the driving signal, it is further determined whether times T of currents detected by the current counter of the three-phase currents is smaller than a preset value n;
if times T is smaller than the preset value n, the current accumulator may accumulate the three-phase currents IA, IB and IC respectively;
if times T is larger than or equal to the preset value n, times T of the three-phase current is reset, and an average value of the accumulated values of IA, IB and IC, and the average value may be used in subsequent open phase determination.

Because the open phase is not frequently occurred, if the open phase determination is frequently performed, the process may be complex. Therefore, it is not suitable that the preset value n is too small. However, in order to avoid jump of the current bring misjudgment, the preset value n can not be too big. Therefore, the preset value n is about 1000 to about 10000.

After detecting whether the three-phase currents IA, IB and IC are open phase, the above open phase detection method may further comprise the following steps:
whether the three phases are open phase, all the accumulated three-phase current values IA, IB and IC are reset, then it is further determined whether flag bit of one of three-phase currents is 1;
when the flag bits of the three-phase currents are all zero, that is AF=0, BF=0 and CF=0, the open phase counter count is equal to 0, the process is terminated;
when flag bit of one of three-phase currents is 1, that is when AF=1, BF=1 or CF=1, the open phase counter count may begin to accumulate;
when count is larger than the set value n1, the total flag bit F=1, the control unit 4 may control signal generating unit 1 to stop generating the driving signal, and the process is terminated.

The above set value n1 is in the range of about 10000 to about 120000, that is only if successive open phase times of the three-phase currents is about 10000 to about 120000, the control unit 4 may control the signal generating unit 1 to stop generating the driving signal. Of course, the successive open phase times of the three-phase currents being about 10000 to about 120000 is acceptable and there will be no damage to the motor. If the open phase counter count still don't reach the set value n1, when the flag bits of the three-phase current are all zero, the open phase counter count is reset, that is, the open phase counter count=0.

According to above third embodiment of the present disclosure, open phase detection method further comprises calculating an average value of currents and accumulating the open phase times. However, the aforementioned two steps may not be needed to simultaneously perform in open phase detection method, only one step thereof is also acceptable.

Although explanatory embodiments have been shown and described, it would be appreciated by those skilled in the art that changes, alternatives, and modifications can be made in the embodiments without departing from principles of the disclosure. Such changes, alternatives, and modifications all fall into the scope of the claims and their equivalents.

## Claims

1. An open phase detection system for a three-phase motor (5) of a vehicle during start-up or normal operation of the three-phase motor (5), comprising:
a signal generating unit (1) coupled to the three-phase motor (5) and configured to generate a driving signal for driving the three-phase motor (5);
a detecting unit (2) coupled to the signal generating unit (1), and configured to detect whether the signal generating unit (1) generates the driving signal and to detect three-phase pulse width modulation, PWM, current values of the three-phase motor (5); and
a determining unit (3) coupled to the detecting unit (2), and configured to determine whether the three-phase motor (5) has open phase according to the three phase PWM current values detected by the detecting unit (2) when the driving signal was detected,
**characterized in that** the detecting unit (2) further comprises:
a rotational speed detecting module (230) configured to detect a rotational speed of a vehicle wheel; and
a rotor position detecting module (240) configured to detect a rotor position of the three-phase motor (5),
wherein the determining unit (3) is further configured to determine whether the three-phase motor (5) has open phase according to the rotational speed of the vehicle wheel, the rotor position of the three-phase motor (5), a predetermined duty ratio value a0 of the three phase PWM current values of the three-phase motor (5), and the detected three-phase PWM current values.

2. The system according to the claim 1, further comprising:
a control unit (4) coupled to the signal generating unit (1) and the determining unit (3) respectively, and configured to control the signal generating unit (1) to stop generating the driving signal if open phase was detected.

3. The system according to the claim 1, wherein the detecting unit (2) comprises:
a signal detecting module (210) configured to detect whether the signal generating unit (1) generates the driving signal; and
a current detecting module (220) configured to detect the three phase PWM current values of the three-phase motor (5).

4. The system according to the claim 1, wherein the detecting unit (3) further comprises:
a current counter configured to count times where the detected three phase PWM currents are zero;
a current accumulator configured to accumulate each of the three-phase PWM current values respectively; and
a current calculator configured to compute an average value of the detected PWM current values.

5. The system according to claim 1, wherein the control unit (4) further comprises an open phase counter configured to accumulate times of open phase and is further configured to reset the current accumulator according to determination received from the determining unit.

6. The system according to claim 3, wherein the determining unit (3), the signal generating unit (1) and the control unit (4) are integrated into a piece of chip.

7. An open phase detection method for a three-phase motor (5) of a vehicle during start-up or normal operation of the three-phase motor (5), comprising steps of:
detecting whether a driving signal is generated;
detecting three phase pulse width modulation, PWM, current values of the three-phase motor (5) when the driving signal is detected; and
determining whether the three-phase motor (5) has open phase according to the detected three phase PWM current values,
wherein the method further comprises:
detecting whether a rotational speed of a vehicle wheel is zero when the driving signal is detected; and
determining whether one of the three-phase PWM current values is zero when the rotational speed of a vehicle wheel is not zero; and
determining the three-phase motor (5) to have open phase when one of the three phase PWM current values is zero
wherein the method further comprises:
determining whether the three-phase motor (5) has open phase according to the rotational speed of the vehicle wheel, a rotor position of the three-phase motor (5), a predetermined duty ratio value a0 of the three phase PWM current values of the three-phase motor (5), and the three-phase PWM current values.

8. The method according to claim 7, further comprising:
stopping generating the driving signal when the three-phase motor (5) is determined to have open phase.

9. The method according to claim 7, further comprising:
determining whether an A-phase PWM current value is zero when the rotational speed of the vehicle wheel is zero;
determining whether the rotor position of the three-phase motor is in sector I or sector VI when the A-phase PWM current value is zero;
determining the three-phase motor (5) has open phase if the rotor position of the three-phase motor is not in sector I or sector VI ;
determining whether a duty ratio a1 of the A-phase PWM current is equal to a predetermined duty ratio value a0 when the rotor position of the three-phase motor (5) is in sector I or sector VI ;
determining the A-phase of the motor (5) is not open phase if the duty ratio a1 of A-phase PWM current is equal to the predetermined duty ratio value a0;
determining the three-phase motor (5) has open phase when the duty ratio a1 of the A-phase PWM current is not equal to the predetermined duty ratio value a0;
determining whether the B-phase PWM current value is zero when the A-phase is not open phase;
determining whether the rotor position of the three-phase motor (5) is in sector III or sector IV when the B-phase PWM current value is zero;
determining the three-phase motor (5) has open phase if the rotor position of the three-phase motor is not in sector III or sector IV ;
determining whether a duty ratio a2 of the B-phase PWM current is equal to a predetermined duty ratio value a0 when the rotor position of the three-phase motor (5) is in sector III or sector IV ;
determining the A-phase and B-phase of the motor (5) are not open phase if the duty ratio a1 of B-phase PWM current is equal to the predetermined duty ratio value a0;
determining the three-phase motor (5) has open phase when the duty ratio a2 of the B-phase PWM current is not equal to the predetermined duty ratio value a0;
determining whether the C-phase PWM current value is zero when the A-phase and B-phase are not open phase;
determining whether the rotor position of the three-phase motor (5) is in sector II or sector V when the C-phase PWM current value is zero;
determining the three-phase motor (5) has open phase if the rotor position of the three-phase motor sector is not in sector II or sector V;
determining whether a duty ratio a3 of the C-phase PWM current is equal to a predetermined duty ratio value a0 when the rotor position of the three-phase motor (5) is in sector II or sector V;
determining the three-phase motor (5) has no open phase if the duty ratio a3 of C-phase PWM current is equal to the predetermined duty ratio value a0; and
determining the three-phase motor (5) has open phase when the duty ratio a3 of the C-phase PWM current is not equal to the predetermined duty ratio value a0,
wherein the sector I, the sector II, the sector III, the sector IV, the sector V and the sector VI are arranged parts of the 360° rotation area where the motor rotor rotates.

10. The method according to claim 7, further comprising:
determining whether the number of times T where the detected three phase PWM currents are zero is smaller than a preset value n when the driving signal is detected ;
accumulating the three phase PWM current values IA, IB and IC respectively if times T is smaller than the preset value n;
resetting times T and calculating an average value of the accumulated values of IA, IB and IC if times T is larger than or equal to the preset value n; and
resetting the accumulated values of the three phase PWM current values IA, IB and IC;
determining whether flag bit of one of three phase PWM currents is 1;
resetting an open phase count and terminating operation if the flag bit of each of the three-phase PWM currents is zero; and
accumulating the open phase count when the flag bit of one of three-phase PWM current is 1, and setting open phase flag bit F of the motor to 1 when the open phase count is larger than or equal to a set value n1, and stopping generating the driving signal.

11. The method according to claim 10, wherein the preset value n is in a range of 1000 to 10000; and the set value n1 is in a range of 10000 to 120000.

## Patentansprüche

1. System zur Erkennung offener Phasen für einen Dreiphasenmotor (5) eines Fahrzeugs während des Anlaufens oder des Normalbetriebs des Dreiphasenmotors (5), aufweisend:
eine Signalerzeugungseinheit (1), die mit dem Dreiphasenmotor (5) gekoppelt ist und konfiguriert ist, um ein Ansteuersignal zum Ansteuern des DreiPhasen-Motors (5) zu erzeugen;
eine Erkennungseinheit (2), die mit der Signalerzeugungseinheit (1) gekoppelt ist und konfiguriert ist, um zu erkennen, ob die Signalerzeugungseinheit (1) das Ansteuersignal erzeugt, und um Dreiphasen-Pulsweitenmodulations-, PWM, Stromwerte des Dreiphasenmotors (5) zu erkennen; und
eine Bestimmungseinheit (3), die mit der Erkennungseinheit (2) gekoppelt ist und konfiguriert ist, um zu bestimmen, ob der Dreiphasenmotor (5) eine offene Phase gemäß den Dreiphasen-PWM-Stromwerten, die von der Erkennungseinheit (2) erkannt wurden, wenn das Ansteuersignal erkannt wurde, aufweist,
**dadurch gekennzeichnet, dass** die Erkennungseinheit (2) weiterhin aufweist:
ein Modul (230) zur Erkennung einer Drehzahl, das konfiguriert ist, um eine Drehzahl eines Fahrzeugrads zu erkennen; und
ein Modul (240) zur Erkennung einer Rotorstellung, das konfiguriert ist, um eine Rotorstellung des Dreiphasenmotors (5) zu erkennen,
wobei die Bestimmungseinheit (3) weiterhin konfiguriert ist, um zu bestimmen, ob der Dreiphasenmotor (5) eine offene Phase gemäß der Drehzahl des Fahrzeugrads, der Rotorstellung des Dreiphasenmotors (5), einem vorbestimmten Tastverhältniswert a0 der Dreiphasen-PWM-Stromwerte des Dreiphasenmotors (5) und den erkannten Dreiphasen-PWM-Stromwerten aufweist.

2. System nach Anspruch 1, weiterhin aufweisend:
eine Steuereinheit (4), die jeweils mit der Signalerzeugungseinheit (1) und der Bestimmungseinheit (3) gekoppelt ist und konfiguriert ist, um die Signalerzeugungseinheit (1) zu steuern, so dass sie die Erzeugung des Ansteuersignals stoppt, wenn eine offene Phase erkannt wurde.

3. System nach Anspruch 1, wobei die Erkennungseinheit (2) aufweist:
ein Modul (210) zur Erkennung eines Signals, das konfiguriert ist, um zu erkennen, ob die Signalerzeugungseinheit (1) das Ansteuersignal erzeugt; und
ein Modul (220) zur Erkennung eines Stroms, das konfiguriert ist, um die Dreiphasen-PWM-Stromwerte des Dreiphasenmotors (5) zu erkennen.

4. System nach Anspruch 1, wobei die Erkennungseinheit (3) weiterhin aufweist:
einen Stromzähler, der konfiguriert ist, um Zeiten, in denen die erkannten Dreiphasen-PWM-Ströme null sind, zu zählen;
einen Stromakkumulator, der konfiguriert ist, um jeweils jeden der Dreiphasen-PWM-Stromwerte zu akkumulieren; und
einen Stromrechner, der konfiguriert ist, um einen Mittelwert der erkannten PWM-Stromwerte zu berechnen.

5. System nach Anspruch 1, wobei die Steuereinheit (4) weiterhin einen Zähler für offene Phasen aufweist, der konfiguriert ist, um Zeiten offener Phasen zu akkumulieren, und weiterhin konfiguriert ist, um den Stromakkumulator gemäß der von der Bestimmungseinheit erhaltenen Bestimmung zurückzusetzen.

6. System nach Anspruch 3, wobei die Bestimmungseinheit (3), die Signalerzeugungseinheit (1) und die Steuereinheit (4) in ein Chip-Teil integriert sind.

7. Verfahren zur Erkennung offener Phasen für einen Dreiphasenmotor (5) eines Fahrzeugs während des Anlaufens oder des Normalbetriebs des Dreiphasenmotors (5), aufweisend die folgenden Schritte:
Erkennen, ob ein Ansteuersignal erzeugt wird;
Erkennen von Dreiphasen-Pulsweitenmodulations-, PWM, Stromwerten des Dreiphasenmotors (5), wenn das Ansteuersignal erkannt wird; und
Bestimmen, ob der Dreiphasenmotor (5) eine offene Phase gemäß den erkannten Dreiphasen-PWM-Stromwerten aufweist,
wobei das Verfahren weiterhin aufweist:
Erkennen, ob eine Drehzahl eines Fahrzeugrads null ist, wenn das Ansteuersignal erkannt wird; und
Bestimmen, ob einer der Dreiphasen-PWM-Stromwerte null ist, wenn die Drehzahl eines Fahrzeugrads nicht null ist; und
Bestimmen, dass der Dreiphasenmotor (5) eine offene Phase aufweist, wenn einer der drei Phasen-PWM-Steuerwerte null ist,
wobei das Verfahren weiterhin aufweist:
Bestimmen, ob der Dreiphasenmotor (5) eine offene Phase gemäß der Drehzahl des Fahrzeugrads, einer Rotorstellung des Dreiphasenmotors (5), einem vorbestimmten Tastverhältniswert a0 der Dreiphasen-PWM-Stromwerte des Dreiphasenmotors (5) und den Dreiphasen-PWM-Stromwerten aufweist.

8. Verfahren nach Anspruch 7, weiterhin aufweisend:
Stoppen der Erzeugung des Ansteuersignals, wenn bestimmt wird, dass der Dreiphasenmotor (5) eine offene Phase aufweist.

9. Verfahren nach Anspruch 7, weiterhin aufweisend:
Bestimmen, ob ein A-Phasen-PWM-Stromwert null ist, wenn die Drehzahl des Fahrzeugrads null ist;
Bestimmen, ob die Rotorstellung des Dreiphasenmotors in Sektor I oder Sektor VI ist, wenn der A-Phasen-PWM-Stromwert null ist;
Bestimmen, dass der Dreiphasenmotor (5) eine offene Phase aufweist, wenn die Rotorstellung des Dreiphasenmotors nicht in Sektor I oder Sektor VI ist;
Bestimmen, ob ein Tastverhältnis a1 des A-Phasen-PWM-Stroms gleich einem vorbestimmten Tastverhältniswert a0 ist, wenn die Rotorstellung des Dreiphasenmotors (5) in Sektor I oder Sektor VI ist;
Bestimmen, dass die A-Phase des Motors (5) keine offene Phase ist, wenn das Tastverhältnis a1 des A-Phasen-PWM-Stroms gleich dem vorbestimmten Tastverhältniswert a0 ist;
Bestimmen, dass der Dreiphasenmotor (5) eine offene Phase aufweist, wenn das Tastverhältnis a1 des A-Phasen-PWM-Stroms nicht gleich dem vorbestimmten Tastverhältniswert a0 ist;
Bestimmen, ob der B-Phasen-PWM-Stromwert null ist, wenn die A-Phase keine offene Phase ist;
Bestimmen, ob die Rotorstellung des Dreiphasenmotors (5) in Sektor III oder Sektor IV ist, wenn der B-Phasen-PWM-Stromwert null ist;
Bestimmen, dass der Dreiphasenmotor (5) eine offene Phase aufweist, wenn die Rotorstellung des Dreiphasenmotors nicht in Sektor III oder Sektor IV ist;
Bestimmen, ob ein Tastverhältnis a2 des B-Phasen-PWM-Stroms gleich einem vorbestimmten Tastverhältniswert a0 ist, wenn die Rotorstellung des Dreiphasenmotors (5) in Sektor III oder Sektor IV ist;
Bestimmen, dass die A-Phase und B-Phase des Motors (5) keine offenen Phasen sind, wenn das Tastverhältnis a1 des B-Phasen-PWM-Stroms gleich dem vorbestimmten Tastverhältniswert a0 ist;
Bestimmen, dass der Dreiphasenmotor (5) eine offene Phase aufweist, wenn das Tastverhältnis a2 des B-Phasen-PWM-Stroms nicht gleich dem vorbestimmten Tastverhältniswert a0 ist;
Bestimmen, ob der C-Phasen-PWM-Stromwert null ist, wenn die A-Phase und B-Phase keine offenen Phasen sind,
Bestimmen, ob die Rotorstellung des Dreiphasenmotors (5) in Sektor II oder Sektor V ist, wenn der C-Phasen-PWM-Stromwert null ist;
Bestimmen, dass der Dreiphasenmotor (5) eine offene Phase aufweist, wenn die Rotorstellung des Dreiphasenmotorsektors nicht in Sektor II oder Sektor V ist;
Bestimmen, ob ein Tastverhältnis a3 des C-Phasen-PWM-Stroms gleich einem vorbestimmten Tastverhältniswert a0 ist, wenn die Rotorstellung des Dreiphasenmotors (5) in Sektor II oder Sektor V ist;
Bestimmen, dass der Dreiphasenmotor (5) keine offene Phase aufweist, wenn das Tastverhältnis a3 des C-Phasen-PWM-Stroms gleich dem vorbestimmten Tastverhältniswert a0 ist; und
Bestimmen, dass der Dreiphasenmotor (5) eine offene Phase aufweist, wenn das Tastverhältnis a3 des C-Phasen-PWM-Stroms nicht gleich dem vorbestimmten Tastverhältniswert a0 ist,
wobei Sektor I, Sektor II, Sektor III, Sektor IV, Sektor V und Sektor VI angeordnete Teile des Drehbereichs von 360°, in dem sich der Motomotor dreht, sind.

10. Verfahren nach Anspruch 7, weiterhin aufweisend:
Bestimmen, ob die Anzahl der Zeiten T, in denen die erkannten Dreiphasen-PWM-Ströme null sind, kleiner ist als ein vorgegebener Wert n, wenn das Ansteuersignal erkannt wird;
Akkumulieren jeweils der Dreiphasen-PWM-Stromwerte IA, IB und IC, wenn die Zeiten T kleiner als der vorgegebene Wert n sind;
Rücksetzen der Zeiten T und Berechnen eines Mittelwerts der akkumulierten Werte von IA, IB, IC, wenn die Zeiten T größer als der oder gleich dem vorgegebenen Wert n sind; und
Rücksetzen der akkumulierten Werte der Dreiphasen-PWM-Stromwerte IA, IB, und IC;
Bestimmen, ob ein Flag-Bit eines der Dreiphasen-PWM-Ströme 1 ist;
Rücksetzen eines Zählergebnisses offener Phasen und Beenden des Betriebs, wenn das Flag-Bit jedes der Dreiphasen-PWM-Ströme null ist; und
Akkumulieren des Zählergebnisses offener Phasen, wenn das Flag-Bit eines der Dreiphasen-PWM-Ströme 1 ist, und Einstellen des Flag-Bits F der offenen Phase des Motors auf 1, wenn das Zählergebnis offener Phasen größer als ein oder gleich einem Einstellwert n1 ist, und Stoppen der Erzeugung des Ansteuersignals.

11. Verfahren nach Anspruch 10, wobei der vorgegebene Wert n in einem Bereich von 1000 bis 10000 liegt; und der Einstellwert n1 in einem Bereich von 10000 bis 120000 liegt.

## Revendications

1. Système de détection de coupure de phase pour un moteur triphasé (5) d'un véhicule pendant le démarrage ou le fonctionnement normal du moteur triphasé (5), comprenant :
une unité de génération de signal (1) couplée au moteur triphasé (5) et configurée pour générer un signal de commande pour commander le moteur triphasé (5) ;
une unité de détection (2) couplée à l'unité de génération de signal (1) et configurée pour détecter si l'unité de génération de signal (1) génère le signal de commande et pour détecter des valeurs de courant de modulation de largeur d'impulsion, PWM, triphasé du moteur triphasé (5) ; et
une unité de détermination (3) couplée à l'unité de détection (2) et configurée pour déterminer si le moteur triphasé (5) présente une coupure de phase conformément aux valeurs de courant PWM triphasé détectées par l'unité de détection (2) lorsque le signal de commande a été détecté,
**caractérisé en ce que** l'unité de détection (2) comprend en outre :
un module de détection de vitesse de rotation (230) configuré pour détecter une vitesse de rotation d'une roue de véhicule ; et
un module de détection de position de rotor (240) configuré pour détecter une position du rotor du moteur triphasé (5),
dans lequel l'unité de détermination (3) est configurée en outre pour déterminer si le moteur triphasé (5) comprend une coupure de phase conformément à la vitesse de rotation de la roue de véhicule, la position du rotor du moteur triphasé (5), une valeur de rapport cyclique prédéterminé a0 des valeurs de courant PWM triphasé du moteur triphasé (5), et aux valeurs de courant PWM triphasé détectées.

2. Système selon la revendication 1, comprenant en outre :
une unité de commande (4) couplée à l'unité de génération de signal (1) et à l'unité de détermination (3), respectivement, et configurée pour commander l'unité de génération de signal (1) pour arrêter la génération du signal de commande si une coupure de phase a été détectée.

3. Système selon la revendication 1, dans lequel l'unité de détection (2) comprend :
un module de détection de signal (210) configuré pour détecter si l'unité de génération de signal (1) génère le signal de commande ; et
un module de détection de courant (220) configuré pour détecter les valeurs de courant PWM triphasé du moteur triphasé (5).

4. Système selon la revendication 1, dans lequel l'unité de détection (3) comprend en outre :
un compteur de courant configuré pour compter les périodes dans lesquelles les courants PWM triphasés détectés sont zéro ;
un accumulateur de courant configuré pour accumuler chacune des valeurs de courant PWM triphasé, respectivement ; et
un calculateur de courant configuré pour calculer une valeur moyenne des valeurs de courant PWM triphasé détectées.

5. Système selon la revendication 1, dans lequel l'unité de commande (4) comprend en outre un compteur de coupure de phase configuré pour accumuler des périodes de coupure de phase, et est configurée en outre pour réinitialiser l'accumulateur de courant conformément à la détermination reçue par l'unité de détermination.

6. Système selon la revendication 3, dans lequel l'unité de détermination (3), l'unité de génération de signal (1) et l'unité de commande (4) sont intégrées dans une pièce de puce.

7. Procédé de détection de coupure de phase pour un moteur triphasé (5) d'un véhicule pendant le démarrage ou le fonctionnement normal du moteur triphasé (5), comprenant les étapes suivantes :
détecter si un signal de commande est généré ;
détecter des valeurs de courant de modulation de largeur d'impulsion, PWM, triphasé du moteur triphasé (5) lorsque le signal de commande est détecté ; et
déterminer si le moteur triphasé (5) présente une coupure de phase conformément aux valeurs de courant PWM triphasé détectées,
dans lequel le procédé comprend en outre :
détecter si une vitesse de rotation d'une roue de véhicule est zéro lorsque le signal de commande est détecté ; et
déterminer si une des valeurs de courant PWM triphasé est zéro lorsque la vitesse de rotation d'une roue de véhicule n'est pas zéro ; et
déterminer que le moteur triphasé (5) présente une coupure de phase lorsqu'une des valeurs de courant PWM triphasé est zéro,
le procédé comprenant en outre :
déterminer si le moteur triphasé (5) présente une coupure de phase conformément à la vitesse de rotation de la roue de véhicule, une position du rotor du moteur triphasé (5), une valeur de rapport cyclique prédéterminée a0 des valeurs de courant PWM triphasé du moteur triphasé (5), et aux valeurs de courant PWM triphasé.

8. Procédé selon la revendication 7, comprenant en outre :
arrêter la génération du signal de commande lorsqu'il est déterminé que le moteur triphasé (5) présente une coupure de phase.

9. Procédé selon la revendication 7, comprenant en outre :
déterminer si une valeur de courant PWM de phase A est zéro lorsque la vitesse de rotation de la roue de véhicule est zéro ;
déterminer si la position du rotor du moteur triphasé est dans le secteur I ou le secteur VI lorsque la valeur de courant PWM de phase A est zéro ;
déterminer que le moteur triphasé (5) présente une coupure de phase si la position du rotor du moteur triphasé n'est pas dans le secteur I ou le secteur VI ;
déterminer si un rapport cyclique a1 du courant PWM de phase A est égal à une valeur de rapport cyclique prédéterminée a0 lorsque la position du rotor du moteur triphasé (5) est dans le secteur I ou le secteur VI ;
déterminer que la phase A du moteur (5) n'est pas la coupure de phase si le rapport cyclique a1 du courant PWM de phase A est égal à la valeur de rapport cyclique prédéterminée a0 ;
déterminer que le moteur triphasé (5) présente une coupure de phase lorsque le rapport cyclique a1 du courant PWM de phase A n'est pas égal à la valeur de rapport cyclique prédéterminée a0 ;
déterminer si la valeur de courant PWM de phase B est zéro lorsque la phase A n'est pas la coupure de phase ;
déterminer si la position du rotor du moteur triphasé (5) est dans le secteur III ou le secteur IV lorsque la valeur de courant PWM de phase B est zéro ;
déterminer que le moteur triphasé (5) présente une coupure de phase si la position du rotor du moteur triphasé n'est pas dans le secteur III ou le secteur IV ;
déterminer si un rapport cyclique a2 du courant PWM de phase B est égal à une valeur de rapport cyclique prédéterminée a0 lorsque la position du rotor du moteur triphasé (5) est dans le secteur III ou le secteur IV ;
déterminer que la phase A et la phase B du moteur (5) ne sont pas des coupures de phase si le rapport cyclique a1 du courant PWM de phase B est égal à la valeur de rapport cyclique prédéterminée a0 ;
déterminer que le moteur triphasé (5) présente une coupure de phase lorsque le rapport cyclique a2 du courant PWM de phase B n'est pas égal à la valeur de rapport cyclique prédéterminée a0 ;
déterminer si la valeur de courant PWM de phase C est zéro lorsque la phase A et la phase B ne sont pas des coupures de phase ;
déterminer si la position du rotor du moteur triphasé (5) est dans le secteur II ou le secteur V lorsque la valeur de courant PWM de phase C est zéro ;
déterminer que le moteur triphasé (5) présente une coupure de phase si la position du rotor du secteur du moteur triphasé n'est pas dans le secteur II ou le secteur V ;
déterminer si un rapport cyclique a3 du courant PWM de phase C est égal à une valeur de rapport cyclique prédéterminée a0 lorsque la position du rotor du moteur triphasé (5) est dans le secteur II ou le secteur V ;
déterminer que le moteur triphasé (5) ne présente pas de coupure de phase si le rapport cyclique a3 du courant PWM de phase C est égal à la valeur de rapport cyclique prédéterminée a0 ; et
déterminer que le moteur triphasé (5) présente une coupure de phase lorsque le rapport cyclique a3 du courant PWM de phase C n'est pas égal à la valeur de rapport cyclique prédéterminée a0,
le secteur I, le secteur II, le secteur III, le secteur IV, le secteur V, et le secteur VI étant des parties disposées de la zone de rotation de 360° dans laquelle tourne le rotor du moteur.

10. Procédé selon la revendication 7, comprenant en outre :
déterminer si le nombre de périodes T dans lesquelles les courants PWM triphasés détectés sont zéro est inférieur à une valeur préétablie n lorsque le signal de commande est détecté ;
accumuler les valeurs de courant PWM triphasé IA, IB, et IC, respectivement, si les périodes T sont inférieures à la valeur préétablie n ;
réinitialiser les périodes T et calculer une valeur moyenne des valeurs accumulées de IA, IB et IC si les périodes T sont supérieures à ou égales à la valeur préétablie n ; et
réinitialiser les valeurs accumulées des valeurs de courant PWM triphasé IA, IB et IC ;
déterminer si un bit indicateur d'un des courants PWM triphasés est 1 ;
réinitialiser un comptage de coupures de phase et terminer le fonctionnement si le bit indicateur de chacun des courants PWM triphasés est zéro ; et
accumuler le comptage de coupures de phases lorsque le bit indicateur d'un des courants PWM triphasés est 1, et mettre le bit indicateur F de coupure de phase du moteur à 1 lorsque le comptage de coupures de phase est supérieur à ou égal à la valeur établie n1, et arrêter la génération du signal de commande.

11. Procédé selon la revendication 10, dans lequel la valeur préétablie n est dans une plage comprise entre 1000 et 10000, et la valeur établie n1 est dans une plage comprise entre 10000 et 120000.
